# EUROPÄISCHE PATENTANMELDUNG

(11) **EP 1 339 269 A1**
(43) Veröffentlichungstag der Anmeldung: **27.08.2003**
(21) Anmeldenummer: 03002198.4
(22) Anmeldetag: 04.02.2003
(51) Int. Cl.: H05K 3/22

(54) **Kodierelement für ein elektrisches Modul sowie elektrisches Modul mit einem solchen Kodierelement**

(30) Priorität: 11.02.2002 DE 10205556
(71) Anmelder: Harting Automotive GmbH & Co. KG, 32339 Espelkamp (DE)
(72) Erfinder: Krause, Jens, Dr.-Ing., 32369 Rahden (DE)
(74) Vertreter: Sties, Jochen, Dipl.-Ing.

(57) **Zusammenfassung**

Die Erfindung betrifft ein Kodierelement (16) für ein elektrisches Modul (30), mit mindestens einer Schneide (18), die dafür vorgesehen ist, eine von mehreren auf einem Substrat (10) angeordneten Leiterbahnen (12) zu durchtrennen, wodurch dem elektrischen Modul (30) eine Adresse zugeordnet wird. Die Erfindung betrifft auch ein elektrisches Modul mit einem solchen Kodierelement.

## Beschreibung

Die Erfindung betrifft ein Kodierelement für ein elektrisches Modul, insbesondere für ein serielles Bussystem. Die Erfindung betrifft auch ein elektrisches Modul mit einem solchen Kodierelement.

Serielle Bussysteme sind darauf angewiesen, daß jeder Teilnehmer an der Buskommunikation eine individuelle Adresse hat. Dadurch können Informationen zielgerichtet versendet werden.

Wenn mehrere gleichartige Module an ein Bussystem angeschlossen werden, ist es aus logistischen Gründen von hoher Bedeutung, diese Teile als Gleichteile behandeln zu können. Eine Individualisierung soll erst durch die Montage am Einbauort erfolgen.

Im Stand der Technik bekannt ist die Verwendung von Kodierungsschaltkontakten, die am Einbauort so betätigt werden, daß dem Modul eine individuelle Adresse zugeordnet wird. Da derartige Schaltkontakte eine hohe Zuverlässigkeit haben müssen, ergeben sich hohe Kosten.

Die Aufgabe der Erfindung besteht darin, mit geringem Aufwand eine zuverlässige Kodierung des elektrischen Moduls bei der Montage zu erzielen.

Zu diesem Zweck ist gemäß der Erfindung ein Kodierelement für ein elektrisches Modul vorgesehen, mit mindestens einer Schneide, die dafür vorgesehen ist, mindestens eine von mehreren auf einem Substrat angeordneten Leiterbahnen zu durchtrennen, wodurch dem elektrischen Modul eine Adresse zugeordnet wird. Die Erfindung beruht auf dem Grundgedanken, ein elektrisches Modul durch Zerstören mindestens einer von mehreren Leiterbahnen zu kodieren. Der Zustand der nur zu diesem Zweck vorgesehenen mehreren Leiterbahnen kann von einer elektronischen Schaltung abgefragt werden. In Abhängigkeit von dem Ergebnis dieser Abfrage ordnet die Schaltung dann dem elektrischen Modul eine bestimmte Adresse zu. Da eine Leiterbahn mechanisch sehr einfach zerstört werden kann, nämlich durch die Schneide des Kodierelementes, sind die Kosten für eine auf diese Weise vorgenommene Kodierung sehr viel geringer als die Kosten für die Schaltkontakte, die im Stand der Technik verwendet werden.

Bei den erfindungsgemäßen Ausführungsformen ist wichtig, daß das Kodierelement, wenn es die entsprechende Leiterbahn durchtrennt hat, parasitäre Kontakte durch Rückfederung der Enden der durchtrennten Leiterbahn verhindert. Dies ist zuverlässig gewährleistet, wenn die Schneide aus einem elektrisch isolierenden Material besteht. Wenn dagegen die Schneide aus Metall besteht, ist sie vorzugsweise in ein Halteteil aus einem elektrisch isolierenden Material eingebettet, wobei das elektrisch isolierende Material in der Endstellung des Kodierelements die Isolierung der beiden Leiterenden voneinander gewährleistet.

Gemäß einer bevorzugten Ausführungsform der Erfindung ist vorgesehen, daß die Schneide auf einer Seite mit einer ebenen Anlagefläche versehen ist, die mit einer Schneidmatrize zusammenwirkt, die am elektrischen Modul vorgesehen ist. Die Schneidmatrize dient als Widerlager und erleichtert das Durchschneiden der Leiterbahnen und des Substrats.

Gemäß einer bevorzugten Ausführungsform der Erfindung ist an dem Kodierelement mindestens ein Zentrierstift vorgesehen, der in eine Öffnung im Substrat eingreifen kann. Der Zentrierstift dient zur Führung des Kodierelementes, wenn die Schneide des Kodierelementes das Substrat zertrennt. Die Öffnung im Substrat dient dazu, ein weiteres Zerreißen des Substrates auf den Bereich zwischen beispielsweise zwei einander gegenüberliegenden Öffnungen zu begrenzen. Zusätzlich kann vorgesehen sein, an einer solchen Öffnung eine Kerbe in Reißrichtung vorzusehen, die das Einreißen des Substrates erleichtert.

Gemäß einer bevorzugten Ausführungsform der Erfindung ist vorgesehen, daß das Kodierelement als Gegenstecker ausgebildet ist, der in das elektrische Modul eingesteckt werden kann. Zur Kodierung einen und desselben elektrischen Moduls werden unterschiedliche Kodierelemente bereitgehalten, die sich beispielsweise durch ihre Farbgebung unterscheiden. Die Schneiden der unterschiedlichen Kodierelemente sind an unterschiedlichen Stellen angeordnet, so daß beim Einstecken des Kodierelementes jeweils nur eine bestimmte Leiterbahn unterbrochen und auf diese Weise die gewünschte Kodierung erhalten wird.

Gemäß einer alternativen Ausführungsform ist vorgesehen, daß das Kodierelement als Reiter ausgebildet ist, der verschiebbar an dem elektrischen Modul angebracht ist. Das Kodierelement kann dann so ähnlich wie ein Schaltkontakt zwischen verschiedenen Positionen verstellt werden. Erst wenn sich das Kodierelement in der gewünschten Position befindet, wird dafür gesorgt, daß das Substrat mit den Leiterbahnen auf den mit dem Kodierelement versehenen Bereich aufgedrückt wird und es zur Zerstörung der Leiterbahnen kommt. Dies kann beispielsweise dadurch geschehen, daß das elektrische Modul im Anlieferungszustand einen offenen Gehäusedeckel aufweist, der erst dann geschlossen wird, wenn das Kodierelement zum Zwecke der Kodierung in die gewünschte Position gebracht wurde. Der Gehäusedeckel preßt beim Schließen das Substrat so gegen das Kodierelement, daß die entsprechende Leiterbahn unterbrochen wird.

Die Erfindung betrifft auch ein elektrisches Modul mit einer Aufnahme für ein Kodierelement. Ein solches elektrisches Modul kann immer in derselben Ausführung geliefert werden. Die zur Verwendung im Bussystem erforderliche individuelle Adresse wird dem elektrischen Modul erst durch das Einstecken des entsprechenden, individuellen Kodierelementes gegeben.

Vorteilhafte Ausgestaltungen der Erfindung ergeben sich aus den Unteransprüchen.

Die Erfindung wird nachfolgend anhand von verschiedenen Ausführungsformen beschrieben, die in den beigefügten Zeichnungen dargestellt sind. In diesen zeigen:
- Figur 1 in einer schematischen, perspektivischen Ansicht ein Kodierelement, bevor es auf das Substrat aufgedrückt wird und eine Leiterbahn durchtrennt;
- Figur 2 in einer anderen perspektivischen Ansicht das Kodierelement und das Substrat von Figur 1;
- Figur 3 in einer perspektivischen Ansicht eine andere Ausführungsform des Kodierelementes;
- Figur 4 in einer schematischen Schnittansicht eine Leiterbahn, die von einer Schneide gemäß einer Ausführungsvariante unterbrochen ist;
- Figur 5 in einer schematischen Schnittansicht eine Leiterbahn, die von einer Schneide gemäß einer weiteren Ausführungsvariante unterbrochen ist;
- Figur 6 in einer Schnittansicht ein Kodierelement mit einer Schneide gemäß einer weiteren Ausführungsvariante;
- Figur 7 in einer schematischen Schnittansicht ein erfindungsgemäßes elektrisches Modul;
- Figur 8 in einer vergrößerten Draufsicht ein Substrat mit mehreren Leiterbahnen, das bei dem elektrischen Modul von Figur 7 verwendet wird, wobei sich das Substrat im Zustand vor der Kodierung befindet; und
- Figur 9 das Substrat mit den Leiterbahnen von Figur 8, wobei eine Kodierung vorgenommen wurde.

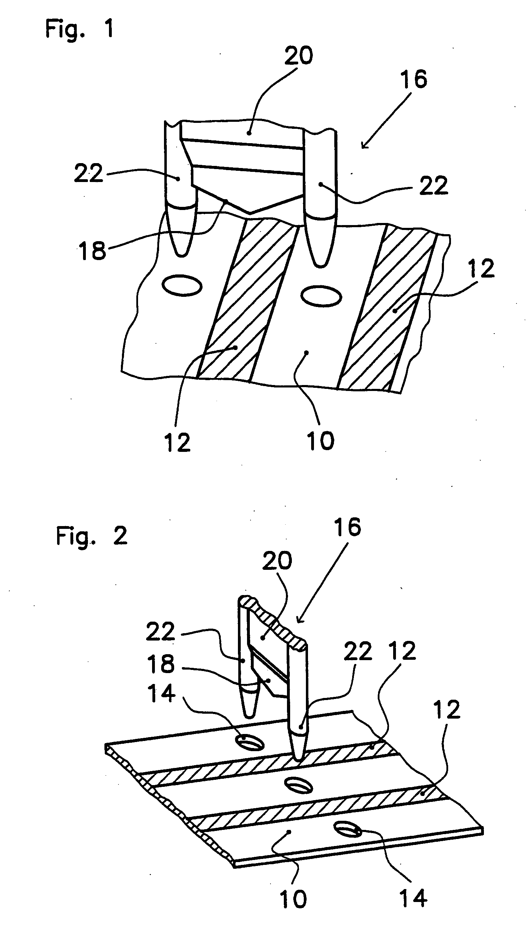

In den Figuren 1 und 2 ist ein Substrat 10 gezeigt, das mit mehreren Leiterbahnen 12 versehen ist. Bei dem Substrat kann es sich insbesondere um eine flexible Leiterfolie handeln. Im Substrat sind mehrere Öffnungen 14 vorgesehen, die paarweise auf der einen und der anderen Seite einer Leiterbahn 12 liegen.

Es ist ein Kodierelement 16 gezeigt, das bei der Ausführungsform gemäß den Figuren 1 und 2 eine Schneide 18 aufweist, die in einem Halteteil 20 angeordnet ist. An jedem seitlichen Ende der Schneide 18 ist ein Zentrierstift 22 angeordnet, dessen vorderes Ende konisch zuläuft und dessen Durchmesser etwa dem Durchmesser der Öffnungen 14 entspricht.

Das Kodierelement 16 ist dafür vorgesehen, auf das Substrat 10 so aufgesteckt zu werden, daß die Schneide 18 diejenige Leiterbahn 12 durchtrennt, die zwischen den beiden Öffnungen 14 liegt, in welche die Zentrierstifte 22 eingreifen.

Das Zerschneiden der entsprechenden Leiterbahn 12 wird bei dem Kodierelement gemäß den Figuren 1 und 2 dadurch erleichtert, daß die Schneide 18 aus zwei schräg angeordneten Teilstücken besteht, die sich in der Mitte in einer Spitze treffen. Ein unbeabsichtigtes Weiterreißen des Substrates in Bereichen, die nicht von der Schneide 18 zerschnitten werden, ist zuverlässig verhindert von den Öffnungen 14, die als Rißstopmittel dienen.

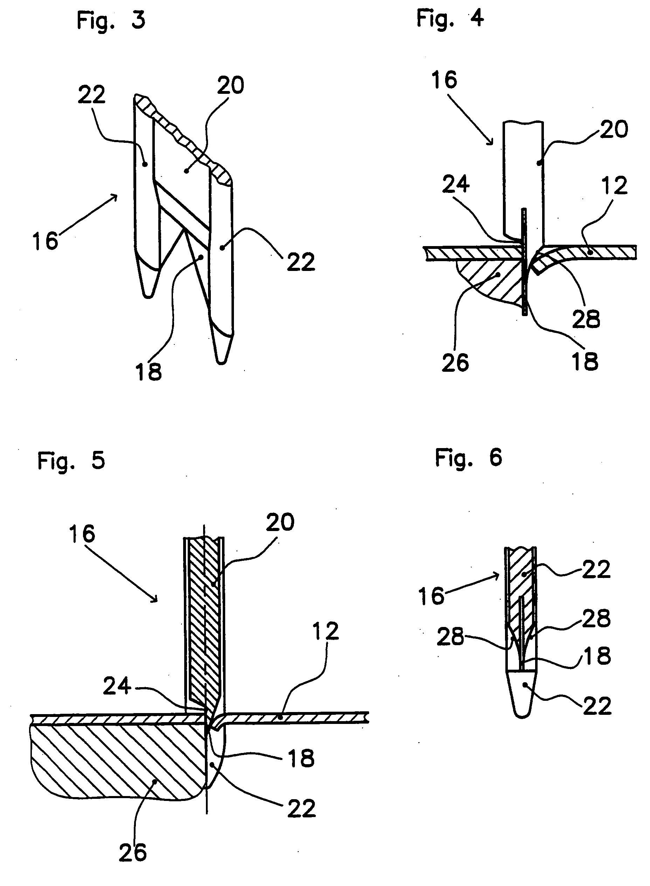

In Figur 3 ist ein Kodierelement mit einer alternativen Ausgestaltung der Schneide 18 gezeigt. Im Unterschied zu der in den Figuren 1 und 2 gezeigten Ausführungsform sind hier die Teilstücke der Schneide 18 so angeordnet, daß sie eine in Steckrichtung nach hinten verlaufende Kerbe bilden; die Schneide 18 greift also beim Einstecken des Kodierelementes 16 zuerst im Bereich der Öffnungen 14 am Substrat an. Das Einreißen des Substrates kann dadurch unterstützt werden, daß am Rand der Öffnungen 14 kleine Kerben auf einer gedachten Verbindungslinie zwischen den beiden Öffnungen vorgesehen sind.

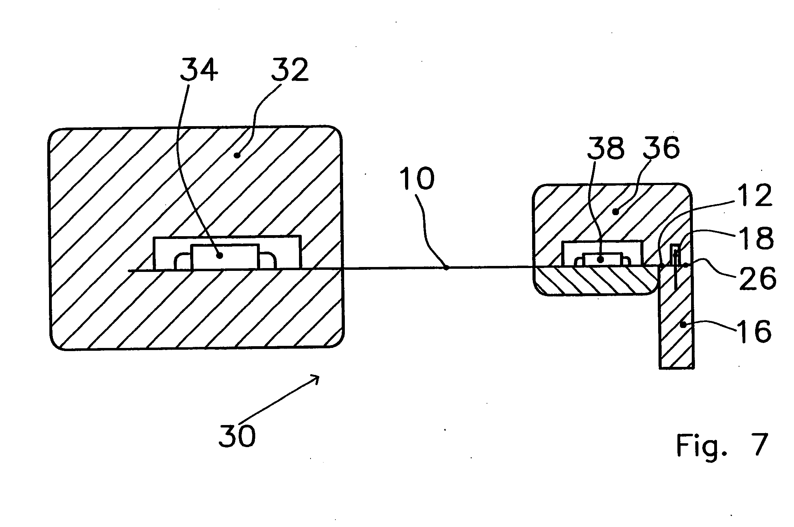

In Figur 4 ist ein Kodierelement 16 im Schnitt zusehen, bei dem die Schneide 18 aus Metall besteht, die in das Halteteil 20 eingebettet ist. Das Halteteil 20 besteht aus einem isolierenden Kunststoff. Eine Seite der Schneide 18, nämlich die in Figur 4 linke Seite, ist als ebenen Anlagefläche 24 ausgebildet, die mit einer auf der Rückseite des Substrates angeordneten Schneidmatrize 26 zusammenwirkt. Die Schneidmatrize 26 ist Teil eines elektrischen Moduls (siehe Figur 7) und dient zur Abstützung des Substrates 10 beim Schneiden, so daß ein sauberer Schnitt gewährleistet ist. Auf der der Anlagefläche 24 gegenüberliegenden Seite der Schneide 18 ist das Halteteil 24 mit einer gekrümmten Ablenkfläche 28 versehen, die gewährleistet, daß das auf der rechten Seite der Schneide 18 befindliche Ende der unterbrochenen Leiterbahn 12 die Schneide 18 nicht berührt. Auf diese Weise ist gewährleistet, daß die elektrisch leitende Schneide 18 nicht einen unbeabsichtigten Kontakt zwischen den an sich getrennten Enden der Leiterbahn 12 herstellt.

In Figur 5 ist eine alternative Ausgestaltung des Kodierelementes 16 gezeigt. Im Unterschied zu dem in Figur 4 gezeigten Kodierelement ist hier die Schneide 18 einstückig mit dem Halteteil 20 ausgeführt; die Schneide 18 besteht also aus einem elektrisch isolierenden Material. Der Vorteil gegenüber dem in Figur 4 gezeigten Kodierelement besteht darin, das mit noch größerer Zuverlässigkeit verhindert ist, daß das Kodierelement den Kontakt zwischen den an sich getrennten Enden der Leiterbahn 12 herstellt. Außerdem kann ein vollständig aus Kunststoff bestehendes Kodierelement sehr günstig hergestellt werden. Der Nachteil besteht darin, daß eine Schneide aus Kunststoff üblicherweise nicht so scharf ausgeführt werden kann wie eine Schneide aus Metall, so daß zum Aufsetzen des Kodierelementes auf das Substrat höhere Kräfte erforderlich sind.

In Figur 6 ist eine weitere Ausführungsvariante eines Kodierelementes gezeigt, bei dem ähnlich wie bei dem Kodierelement von Figur 4 eine Schneide 18 aus Metall verwendet wird. Bei dem Kodierelement gemäß Figur 6 ist die Ablenkfläche 28 jedoch auf jeder Seite der Schneide 18 vorgesehen. Dies ergibt eine größere räumliche Trennung der Enden der unterbrochenen Leiterbahn voneinander.

In Figur 7 ist ein elektrisches Modul 30 gezeigt, das beispielsweise ein Gewichtssensor sein kann, mit dem die Belegung eines Fahrzeugsitzes erkannt werden kann. Jedem Fahrzeugsitz ist ein eigener Gewichtssensor zugeordnet, die alle zusammen über ein Bussystem mit einer zentralen Steuereinheit kommunizieren.

Das elektrische Modul 30 besteht aus einem Sensor 32, von dem hier schematisch eine Sensorschaltung 34 gezeigt ist. Die Sensorschaltung 34 ist auf einem elektrischen Schaltungsträger in der Form einer flexiblen Leiterfolie angeordnet, die mit dem Substrat 10 identisch ist. Auf dem Substrat 10 ist auch ein Adreßbauteil 36 angeordnet, das mit einer Adreßschaltung 38 versehen ist. In das Adreßbauteil 36 kann das Kodierelement 16 eingesteckt werden. Das Kodierelement 16 ist als Gegenstecker ausgebildet, von dem so viele unterschiedliche Varianten verfügbar sind, wie unterschiedliche Kodierungen gewünscht werden. Die verschiedenen Kodierelemente passen alle in einen und dieselbe Aufnahme, die am Adreßbauteil 36 vorgesehen ist, und unterscheiden sich nur hinsichtlich der Anordnung der Schneide 18. Damit die verschiedenen Kodierelemente bei der Montage unterschieden werden können, können sie beispielsweise mit unterschiedlicher Farbe ausgeführt sein. Als Aufnahme für das Kodierelement sind beispielsweise Bohrungen ausreichend, in welche die Zentrierstifte eingreifen, die auch in die Öffnungen 14 im Substrat 10 eingreifen.

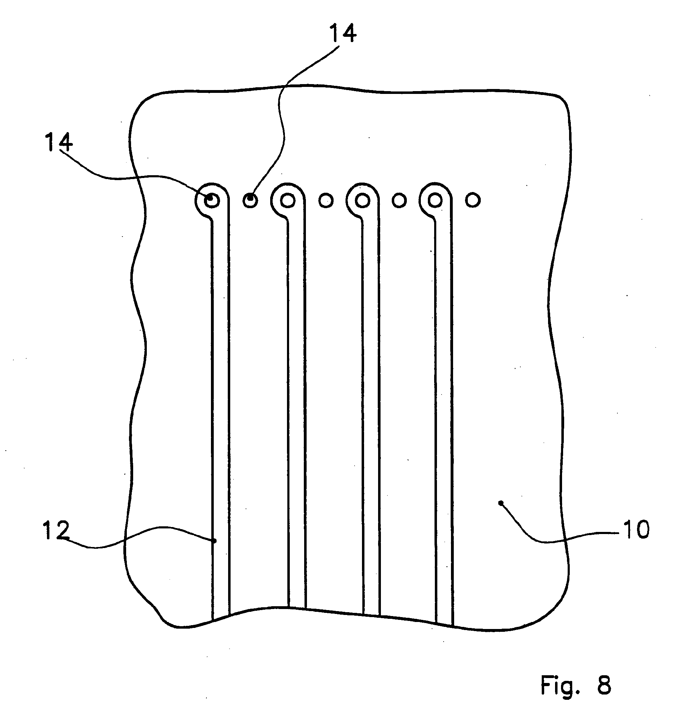

In Figur 8 ist der Abschnitt des Substrates 10 zu sehen, der in dem Bereich des Adreßbauteils 36 frei liegt, in dem das Kodierelement 16 aufgesteckt wird, wobei das Substrat in Figur 8 im Ausgangszustand gezeigt ist, also vor der Montage des Kodierelementes 16. Im Ausgangszustand sind alle Leiterbahnen 12 intakt. Es wird darauf hingewiesen, daß auch das Substrat bereits im Ausgangszustand einen ersten kodierten Zustand hat, der abgefragt werden kann, nämlich eine Kodierung, bei der sämtliche Leiterbahnen intakt sind.

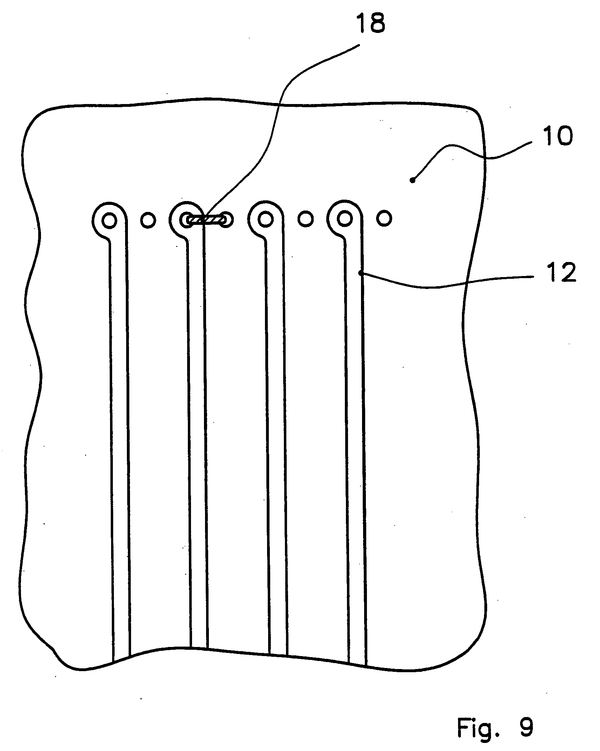

In Figur 9 ist derselbe Abschnitt des Substrates 10 gezeigten wie in Figur 8, mit dem Unterschied, daß ein Kodierelement aufgesteckt wurde, dessen Schneide 18 die zweite Leiterbahn 12 von links unterbrochen hat. Die Adreßschaltung 38 erkennt durch eine Widerstandsmessung, welche der verschiedenen Leiterbahnen 12 unterbrochen ist, und ordnet dem elektrischen Modul 30 in Abhängigkeit hiervon eine bestimmte Adresse zu. Unter dieser Adresse kommuniziert das elektrische Modul über das Bussystem.

Abweichend von der gezeigten Ausführungsform kann das Kodierelement 16 auch mehrere der Leiterbahnen 12 unterbrechen. Auf diese Weise kann die Anzahl der möglichen Adressen erhöht werden.

### Bezugszeichenliste:

- 10:: Substrat
- 12:: Leiterbahn
- 14:: Öffnung
- 16:: Kodierelement
- 18:: Schneide
- 20:: Halteteil
- 22:: Zentrierstift
- 24:: Anlagefläche
- 26:: Schneidmatrize
- 28:: Ablenkfläche
- 30:: elektrisches Modul
- 32:: Sensor
- 34:: Sensorschaltung
- 36:: Adreßbauteil
- 38:: Adreßschaltung

## Patentansprüche

1. Kodierelement (16) für ein elektrisches Modul (30), mit mindestens einer Schneide (18), die dafür vorgesehen ist, eine von mehreren auf einem Substrat (10) angeordneten Leiterbahnen (12) zu durchtrennen, wodurch dem elektrischen Modul (30) eine Adresse zugeordnet wird.

2. Kodierelement nach Anspruch 1, **dadurch gekennzeichnet, daß** die Schneide (18) aus einem elektrisch isolierenden Material besteht.

3. Kodierelement nach Anspruch 1, **dadurch gekennzeichnet, daß** die Schneide (18) aus Metall besteht und in ein Halteteil (20) aus einem elektrisch isolierenden Material eingebettet ist.

4. Kodierelement nach einem der vorhergehenden Ansprüche, **dadurch gekennzeichnet, daß** die Schneide (18) auf einer Seite mit einer gekrümmten Ablenkfläche (28) versehen ist.

5. Kodierelement nach Anspruch 4, **dadurch gekennzeichnet, daß** die Schneide (18) auf der gegenüberliegenden Seite ebenfalls mit einer gekrümmten Ablenkfläche (28) versehen ist.

6. Kodierelement nach Anspruch 4, **dadurch gekennzeichnet, daß** die Schneide auf der gegenüberliegenden Seite mit einer ebenen Anlagefläche (24) versehen ist.

7. Kodierelement nach einem der vorhergehenden Ansprüche, **dadurch gekennzeichnet, daß** mindestens ein Zentrierstift (22) vorgesehen ist, der in eine Öffnung (14) im Substrat (10) eingreifen kann.

8. Kodierelement nach Anspruch 7, **dadurch gekennzeichnet, daß** zwei Zentrierstifte (22) vorgesehen sind und sich die Schneide (18) zwischen den Zentrierstiften (20) erstreckt.

9. Kodierelement nach einem der Ansprüche 7 und 8, **dadurch gekennzeichnet, daß** die Öffnung (14) so ausgebildet ist, daß sie als Rißstopmittel wirkt.

10. Kodierelement nach einem der Ansprüche 7 bis 9, **dadurch gekennzeichnet, daß** am Rand der Öffnung (14) eine Kerbe ausgebildet ist, die das Einreißen des Substrates (10) erleichtert.

11. Kodierelement nach einem der vorhergehenden Ansprüche, **dadurch gekennzeichnet, daß** die Schneide (18) aus zwei schräg angeordneten Teilstücken gebildet ist.

12. Kodierelement nach einem der vorhergehenden Ansprüche, **dadurch gekennzeichnet, daß** es als Gegenstecker ausgebildet ist, der in das elektrische Modul (30) eingesteckt werden kann.

13. Kodierelement nach Anspruch 12, **dadurch gekennzeichnet, daß** es an dem elektrischen Modul (30) angeordnet ist, wobei das Modul (30) eine einzige Aufnahme für das Kodierelement (16) aufweist.

14. Kodierelement nach einem der Ansprüche 1 bis 11, **dadurch gekennzeichnet, daß** es als Reiter ausgebildet ist, der verschiebbar an dem elektrischen Modul (30) angeordnet ist.

15. Elektrisches Modul (30) mit einem Substrat (10), auf dem mehrere Leiterbahnen (12) angeordnet sind, und mit einer Aufnahme für ein Kodierelement (16), das selektiv eine der Leiterbahnen durchtrennen kann, wodurch dem elektrischen Modul (30) eine Adresse zugeordnet wird.
